# EUROPEAN PATENT SPECIFICATION

(11) **EP 2 994 941 B1**
(45) Date of publication and mention of the grant of the patent: **06.03.2019**
(21) Application number: 14725554.1
(22) Date of filing: 05.05.2014
(51) Int. Cl.: H01L 31/0224, H01L 31/05, H01L 31/18, H01L 31/048

(54) **SOLAR PANEL AND METHOD FOR MANUFACTURING SUCH A SOLAR PANEL**
SOLARPANEEL UND VERFAHREN FÜR DIE HERSTELLUNG EINES SOLCHEN SOLARPANEELS
PANNEAU SOLAIRE ET PROCÉDÉ DE FABRICATION D'UN TEL PANNEAU SOLAIRE

(30) Priority: 07.05.2013 NL 2010766; 03.04.2014 NL 2012558
(43) Date of publication of application: 16.03.2016
(73) Proprietor: Stichting Energieonderzoek Centrum Nederland, 1755 LE Petten (NL)
(72) Inventor: GORIS, Maurice Joseph Anna Augustinus, 1755 LE Petten (NL); EERENSTEIN, Willemina, 1755 LE Petten (NL); BENNETT, Ian John, 1755 LE Petten (NL); van ROOSMALEN, Johannes Adrianus Maria, 1755 LE Petten (NL)
(74) Representative: Nederlandsch Octrooibureau
(86) International application number: PCT/NL2014/050286
(87) International publication number: WO 2014/182165

(56) References cited:
- WO-A1-2012/160765
- FR-A1- 2 877 144
- US-A- 4 234 351
- US-A1- 2012 103 408
- US-A1- 2012 234 593
- US-B1- 7 432 596

## Description

### Field of the invention

The present invention relates to a solar panel. Also, the invention relates to a method for manufacturing such a solar panel.

### Background

At present solar panels with EWT or MWT or IBC solar cells comprise a conductive patterned back sheet for contacting the electrical contacts on the rear surface of these types solar cells. Typically, such a back sheet comprises a carrier layer, usually a polymer layer, and a patterned conductive layer made of copper (or copper alloy). For connection of a junction box at the back of the module, the polymer layer at the rear side of the module should be locally opened and the tabs are soldered to the conductive layer. However, the cost of copper is relatively high and presents a bottleneck for implementation of these solar panel types in industry.

US 2012/0234593 A1 describes conductive foils having multiple layers for use in photovoltaic modules and methods of forming the same. Described methods of forming the conductive foils generally include adhering an aluminum foil to a carrier, removing native oxides from a surface of the aluminum foil, and sputtering a metal onto the aluminum foil. A dielectric material and an anticorrosion material may then be applied to the upper surface of the sputtered metal.

WO 2012/160765 A1 describes a multi-junction compound solar cell having a multi-junction cell laminate having the top cell and a bottom cell; a transparent electrode, which is disposed on the light incoming surface of the top cell; a lower electrode having potential of the bottom cell; and a side-surface electrode, which is disposed on the side surface of the solar cell with an insulating layer therebetween, and is electrically connected to the transparent electrode, wherein in the multi-junction compound solar cell, the side-surface electrode is led out to the position of the lower electrode.

In the prior art, alternatives have been considered such as an aluminum based conductive layer, since aluminum is comparatively cheap. However, soldering solar cell contacts or junction box contacts to aluminum is cumbersome, since the wettability of aluminum by the solder is usually poor, yielding poor and relatively unreliable electrical interconnections. Also, a high contact resistance on aluminum is observed when conductive adhesive is used to connect a solar cell contact to the aluminum conductive layer.

To solve these difficulties, prior art aluminum conductor layers on back sheets have been covered by vacuum deposition or cladding of a metal layer with better properties for using conductive adhesive or solder on aluminum and typically higher cost.

Additionally, such deposition techniques are time consuming and thus relatively expensive, and therefore do not provide a solution. Also, for applying solder techniques a layer thickness of 1-2 µm at least is needed.

It is an object of the invention to overcome the disadvantages of the prior art.

### Summary of the invention

The object is achieved by a solar panel provided with a stack comprising at least one solar cell and a back-sheet layer; the at least one solar cell being arranged as a back contacted solar cell with a front surface for receiving radiation and a rear surface provided with electrical contacts; the solar panel further being arranged for electrically contacting to a junction box having one or more conductor contacts; the back-sheet layer having a surface provided with a patterned conductor circuit layer of a first conductive material, the conductor circuit layer being arranged with contacting areas each located at a location corresponding and aligned to a location of either one of the electrical contacts on the at least one solar cell or one of junction box conductor contacts;
the at least one solar cell being arranged on top of the conductor circuit layer with the rear surface of the at least one solar cell facing the patterned conductor circuit surface; each electrical contact of the at least one solar cell or junction box conductor contact being in conductive contact with a corresponding one of the contacting areas on the conductor circuit by a body of conductive connecting material; the conductor circuit layer comprising at the location of the contacting area a patch or islet of a second conductive material wherein each patch is arranged in between the body of conductive connecting material on either the one electrical contact or the one junction box conductor contact and the layer of the first conductive material.

Advantageously, the solar panel provides a back sheet which has good interconnection properties as patches are only at locations where properties such as good electrical contact and mechanical adhesion are required. This saves on the amount of the relatively costly metal with these properties to be used in the production of the solar panel. Thus, a solar panel can have a conductive circuit layer of a low cost first material that has poor interconnection properties, with only local patches of a second material with good properties where needed.

Solar cell contacts or junction box conductors or combinations thereof can be contacted with such patched contacts. Solar cell contacts will be contacted typically on a front side of the back sheet (i.e., the surface side facing towards the radiation receiving surface of the solar panel). Junction box conductor contacts are typically contacted on a rear side of the solar panel, although in some embodiments junction box conductor contacts could be provided on the front side of the solar panel.

According to the invention there is provided a solar panel as described above, wherein the first conductive material is an aluminum based metal.

According to an aspect of the invention there is provided a solar panel as described above, wherein the second conductive material is selected from a group comprising a copper based material, a tin based material and a nickel based material.

According to an aspect of the invention there is provided a solar panel as described above, wherein each patch has an areal size that substantially matches the area of a contact on the solar cell.

According to an aspect of the invention there is provided a solar panel as described above, wherein the patch areal size has a diameter of about 2 mm.

According to the invention there is provided a solar panel as described above, wherein the patch of second conductive material has penetrated a native oxide layer on the first conductive material and directly contacts the first conductive material.

According to an aspect of the invention there is provided a solar panel as described above, wherein a thickness of the islets of second conductive material does not exceed 50 micron.

According to an aspect of the invention there is provided a solar panel as described above, wherein the solar panel comprises a back panel that covers a rear surface of the solar panel, the back panel being provided with openings that correspond and are aligned to a respective location of each of the junction box conductor contacts.

Additionally, the present invention relates to a method for manufacturing a solar panel provided with a stack comprising at least one solar cell, a back-sheet layer and a junction box, comprising:
- providing the at least one solar cell being arranged as a back contacted solar cell with a front surface for receiving radiation and a rear surface provided with electrical contacts;
- providing a back-sheet layer having a conductive surface of a first conductive material;
- patterning the conductive surface with a conductor circuit layer being arranged with a layout of contacting areas each located at a location corresponding and aligned to a location of either a corresponding one of the electrical contacts on the at least one solar cell or corresponding one of junction box contacts;
- placing the at least one solar cell on top of the conductor circuit layer with the rear surface of the at least one solar cell facing the patterned conductor circuit surface;
- conductively contacting either each electrical contact of the at least one solar cell or each junction box conductor contact with a corresponding one of the contacting areas on the conductor circuit by a body of conductive connecting material;
- creating at the location of each contacting area a patch or islet of a second conductive material before said conductively contacting each electrical contact with the corresponding contacting area, with each patch being arranged in between the body of conductive connecting material on either one electrical contact or one junction box conductor contact and the layer of the first conductive material, wherein the creation of each patch comprises an application of a second conductive material.

In an embodiment, the application of the second conductive material comprises a cold spraying by a spraying device.

According to this embodiment, the method uses cold spraying to apply the metal. In this manner, the patch of second conductive material is applied under atmospheric conditions at typically room temperature. In comparison with the prior art vacuum technology, the method of the present invention is relatively simple, less time consuming and lower in cost.

In a further embodiment, the cold spraying comprises positioning an outlet of the spraying device at the location of each contacting area on the conductor circuit layer that corresponds to the location of the corresponding electrical contact on the at least one solar cell. As a result, the method allows to create patches only at predetermined locations on the conductor circuit layer of the back sheet.

In yet a further embodiment, the positioning of the outlet of the spraying device is done by a positioning robot.

Advantageously, this allows the method to be automated and to be implemented in high volume production facilities.

According to an aspect of the invention there is provided a method as described above, comprising:
- selecting the second conductive material from a group comprising a copper based material, a tin based material and a nickel based material.

According to an aspect of the invention there is provided a method as described above, further comprising steps of:
- providing a back panel that covers a rear surface of the solar panel; - creating openings in the back panel that correspond and are aligned to a respective location of each of the junction box conductor contacts.

According to an aspect of the invention there is provided a method as described above, wherein the application of the second conductive material comprises one selected from a group comprising ultrasonic bonding of the second conductive material on the first conductive material, chemical plating of the second conductive material on the first conductive material.

According to an aspect of the invention there is provided a method as described above wherein the application of the second conductive material comprises creating a coating of the second conductive material on the first conductive material by a pyrotechnic multilayered film.

Each of these method steps can be applied to both patches for connecting to solar cell contacts or to junction box conductor contacts.

The ultrasonic bonding provides that a patch of the second conductive material (for example copper, or copper based material or a tin based material or a nickel based material) is bonded to the first conductive material such as aluminum.

In an exemplary case for a junction box conductor contact, a piece of copper (for example, a thin plate, or foil) can be ultrasonically bonded to the aluminum after the back-sheet has been opened on the rear side at the location of the contacts. The most probable process is to open the polymer layer before the module is built (i.e. before lamination) and bond the copper material to the back sheet using a large bond head to maximize the bond area. Bonding can be done from the copper or the aluminum side of the back-sheet. The module is then built and laminated after which the cables can be soldered to the copper. The thin plate or foil to be bonded may have a size corresponding to a size of the opening in the back sheet.

Chemical plating of a second conductive material could be achieved by limiting the presence of corrosive and reactive agents forming the patch of second conductive material, to the opening that defines the location of the patch to be created during the deposition process. For example, a masking technique could be applied.

The patch of second conductive material could alternatively be created by a pyrotechnic technique in which a multilayered foil is arranged in the opening in the polymer layer at the location of the patch to be created. The multilayered foil consists of thin layers of two (or more) different materials arranged in a stack. The stacked arrangement is typically metastable at work temperature as at higher temperature the different materials tend to form a compound as a reaction product in an exothermic reaction. The exothermic reaction could be triggered by a heat pulse. The reaction heat from the exothermic reaction will produce a bonding of the compound as a patch of second conductive material on the first conductive material.

According to an aspect of the invention there is provided a method as described above, wherein the back-sheet layer comprises an insulating carrier layer and a conductive layer of the first conductive material and
said patterning the conductive surface of the back sheet comprises milling the back sheet to create the conductor circuit layer.

According to an aspect of the invention there is provided a method as described above, wherein the insulating carrier layer comprises either a base polymer layer or a base glass layer or in general a base isolator material layer.

According to an aspect of the invention there is provided a method as described above, wherein preceding the application of the second conductive material, a masking layer is positioned on the conductor circuit layer; openings in the masking layer being defined for exposing the location of each patch on the conductor circuit layer during the application of the second conductive material.

According to an aspect of the invention there is provided a method as described above, further comprising: removal of the masking layer after said application.

According to an aspect of the invention there is provided a method as described above, further comprising:
- from a rear side of the solar panel creating an opening in at least the insulating carrier layer upto an interface between the insulating carrier layer and the first conductive material layer;
- creating at the location of the opening in at least the insulating carrier layer a rear surface patch or islet of the second conductive material in the first conductive material layer;
- conductively contacting a contact of a junction box device with the rear surface patch of second conductive material through the opening in at least the insulating carrier layer, wherein the creation of each rear surface patch comprises the application of the second conductive material.

According to an aspect of the invention there is provided a method as described above, comprising:
providing at the rear side of the solar panel a support layer or back-panel on the insulating carrier layer, and before the creation of the opening in the insulating carrier layer, creating an opening in the support layer to the insulating carrier layer.

The present invention also relates to a tool for use in the method for manufacturing of a solar panel provided with a stack comprising at least one solar cell and a back-sheet contact layer as described above, comprising:
a supporting surface for supporting at least the back-sheet layer,
and an cold spraying application device for applying each patch on the conductor circuit layer.

According to an aspect of the invention there is provided a tool as described above, wherein the cold spraying application device comprises a cold spraying device mounted on a positioning robot, the robot being configured to position the cold spraying device along the supporting surface.

According to an aspect of the invention there is provided a tool as described above, further comprising a milling device.

Advantageous embodiments are further defined by the dependent claims.

### Brief description of drawings

The invention will be explained in more detail below with reference to a few drawings in which illustrative embodiments thereof are shown. They are intended exclusively for illustrative purposes and not to restrict the inventive concept, which is defined by the claims.

In the following figures, the same reference numerals refer to similar or identical components in each of the figures.
Figure 1 shows a schematic cross-section of a solar panel with MWT solar cells;
Figure 2A shows a plane view of a rear surface of two adjacent solar cells;
Figure 2B shows a plane view of a surface of a back sheet provided with a patterned conductor circuit layer, according to an embodiment of the invention.;
Figures 3A - 3C show a cross-section of the patterned conductor circuit layer at a location of a contacting area with a rear contact of a solar cell in accordance with a respective embodiment of the invention;
Figures 4A - 4C show a cross-section of the patterned conductor circuit layer at a location of a second contacting area of the circuit layer with a contact of a junction box on a rear side of the solar panel module in accordance with a respective embodiment of the invention;
Figure 5 shows schematically a tool according to an embodiment of the invention.

### Detailed description of embodiments

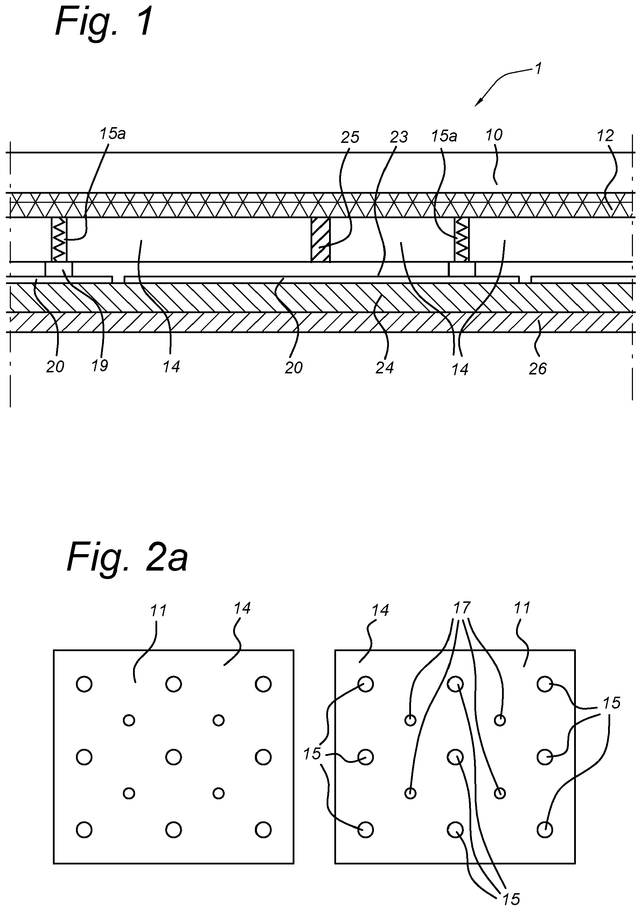

Figure 1 shows a schematic cross-section of a solar panel with MWT solar cells.

A solar panel construction 1 comprises a transparent front layer 10, and a plurality of solar cells 14, a conductor circuit layer 20 and an insulating carrier 24.

The plurality of solar cells 14 are arranged adjacent to each other. Each solar cell which comprises a semiconductor substrate is arranged as a back contacted solar cell with a front surface for receiving radiation from a radiation source such as the Sun. The front surface of each solar cell is directed towards and attached to the transparent front layer 10 of the panel 1. Typically, the solar cell is attached to the transparent front layer 10 by a transparent adhesive polymer layer 12 or in some cases by a transparent glass frit layer 12.

In a back contacted solar cell both cathode and anode electrical contacts 15, 17 are all arranged at the rear surface. Back contacted solar cells may be of the MWT (metal-wrap-through), or alternatively either EWT (Emitter wrap-through), or IBC (interdigitated back-contact) or other back-contact silicon substrate type, that comprise all contacts at the rear of the cell either by conductive vias through the silicon substrate to connect the front surface region with rear surface electrical contact(s) of the solar cell or by having both the p- and n-type junctions and electrical contact(s) at the rear of the solar cell.

As an example, in metal wrap through (MWT) solar cells, metal conductors (or vias) 15a run through the semiconductor substrate to bring electrical contacts from the substrate's front surface to the rear surface. (In figure 1 only the MWT contacts that collect charge carriers from the front surface of the solar cell are shown).

Both cathode and anode contacts are connected to a conductor circuit layer 20 supported by the insulating carrier layer 24. As an isolation usually a transparent adhesive polymer layer 23 is present between the solar cell rear surface and the conductor circuit layer, with openings in the intermediate isolation at the location of the solar cell contacts. The conductor circuit layer 20 is patterned to have a layout to connect the contacts of the solar cells in either serial or parallel connection (depending on the design).

It will be appreciated that alternatively, the insulating carrier layer 24 may be either a polymer layer or a glass layer or, in general, an isolator material.

Typically, the connection between an electrical contact on the solar cell and the conductor circuit layer is made by a solder or conductive adhesive body 19.

In between adjacent solar cells isolation 25 may be present. Additional back support layers 26 may be arranged under the insulating carrier 24.

Figure 2a shows a plane view of a rear surface of two adjacent solar cells 14.

On the rear surface 11 of each solar cell 14, a number of cathode and anode electrical contacts 15, 17 are arranged. In this non-limiting example, electrical contacts 15 of one polarity are arranged in three parallel rows with two parallel rows of electrical contacts 17 of the opposite polarity in between them.

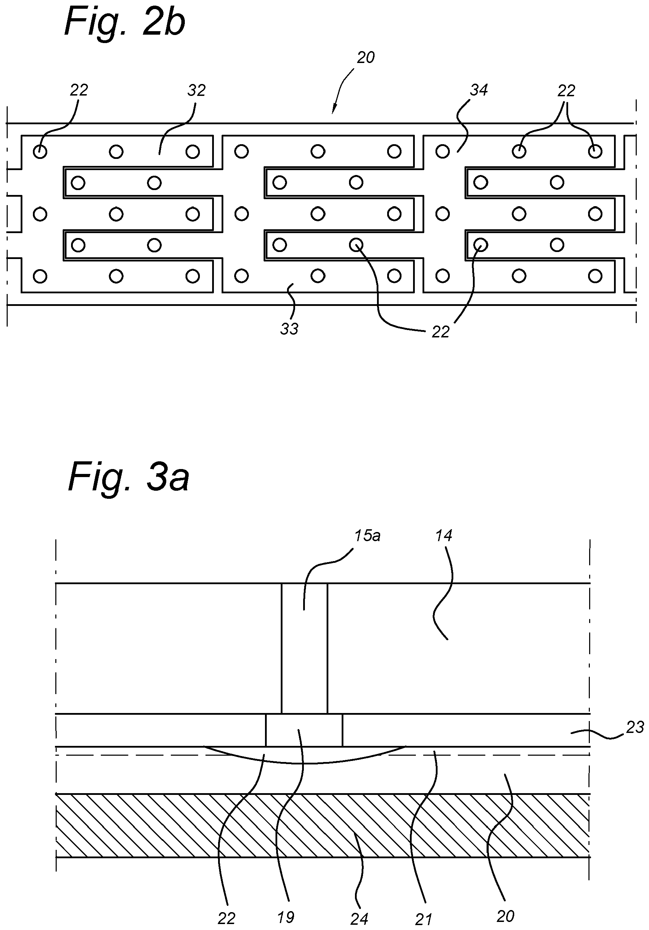

Figure 2b shows a plane view of a surface of a back sheet provided with a patterned conductor circuit layer 20, according to an embodiment of the invention. The layout of the conductor circuit layer 20 corresponds with the layout of the electrical contacts of the back-contacted solar cells of Figure 2a.

The conductor circuit layer comprises one or more patterned conductive areas 32, 33, 34. For example, the conductive areas may be interdigitated, but other pattern shapes and pattern arrangements are also possible, as will be appreciated by the person skilled in the art. Further, it is noted that the layout of the conductor circuit layer matches substantially the layout of the electrical contacts 15, 17 on the rear surface of the back-contacted solar cells 14 and with the arrangement of the solar cells 14 next to each other.

As mentioned above, in the prior art the conductor circuit layer 20 is a copper based layer, which has high conductance and good contacting properties for solders and conductive adhesives. Such a copper layer is relatively costly, however.

As an alternative the conductor circuit layer 20 is an aluminum based layer, with relatively high conductance and relatively low cost. Adversely, the wettability of aluminum by the solder or conductive adhesive is poor, yielding poor and relatively unreliable electrical interconnections between a solar cell contact and the conductor circuit layer.

As shown in figure 2b, the present invention provides that at the predetermined location of the contacting area of the solar cell contact and the conductor circuit layer a patch 22 or islet of a second conductive material is applied. The patch 22 is arranged in between the solder body 19 on the corresponding electrical contacts 15, 17 and the layer of aluminum based material.

The second conductive material is selected from a group of conductive materials that has good wettability properties for conductive contact with the solder or conductive adhesive body 19 on the solar cell.

In a further embodiment, the second conductive material is selected based on having good soldering properties with the soldering material and/or to be compatible with conductive adhesives in the connection 19 between the solar cell contact and the conductive circuit layer 20.

According to an embodiment, the second conductive material is selected from a group comprising a copper based material, a tin based material and a nickel based material.

The application of the second conductive material on the first conductive material of the one or more patterned conductive areas 32, 33, 34 can be done in various manners.

The application can be done by a cold spraying process.

Preferably, the second conductive material is applied on the aluminum based material by cold spraying, i.e., a powder of the second conductive material is mixed with a gas flow, sprayed at high flow rate and at relatively low temperature on the surface of the aluminum based material. The term "low temperature" is defined as a temperature well below melting temperature of the first and second conductive material to avoid damage to the first conductive material.

The term "high flow rate" is defined as the rate necessary to crush or breakthrough the oxide layer on the aluminum carrier foil and to deform the particles in such a way that a compact dense layer is formed.

The application of the patches of the second conductive material on the aluminum based conductor circuit layer 20 can be done in various manners.

The application of the patches by cold spraying can be done using a spraying device with a nozzle that focuses the sprayed second conductive material powder to form a patch at the location of each contacting area on the conductor circuit layer that corresponds to the location of the corresponding electrical contact on the at least one solar cell. In an embodiment, this method can be implemented by using a positioning robot that is coupled to the spraying device. The conductor circuit layer can be positioned on a supporting table coupled to the robot. The robot can position the nozzle of the spraying device in accordance with the predetermined locations for the patches 22 on the conductor circuit layer 20.

Alternatively, a masking layer can be positioned on the conductor circuit layer. In the masking layer openings have been defined for exposing the conductor circuit layer at the locations under the openings to create patches there during cold spraying. After cold spraying the masking layer is removed.

Alternatively, the application can be done by an ultrasonic bonding process of a thin plate or foil of the second conductive material with the first conductive material.

The ultrasonic bonding provides that a patch of the second conductive material (for example copper, or copper based material or a tin based material or a nickel based material) is bonded to the first conductive material such as aluminum.

In a further alternative embodiment, a chemical or electrochemical plating process can be used to apply patches of the second conductive material on the one or more patterned conductive areas 32, 33, 34 of first conductive material.

In yet another alternative embodiment, a pyrotechnic "welding" process can be used to create patches of the second conductive material on the one or more patterned conductive areas 32, 33, 34.

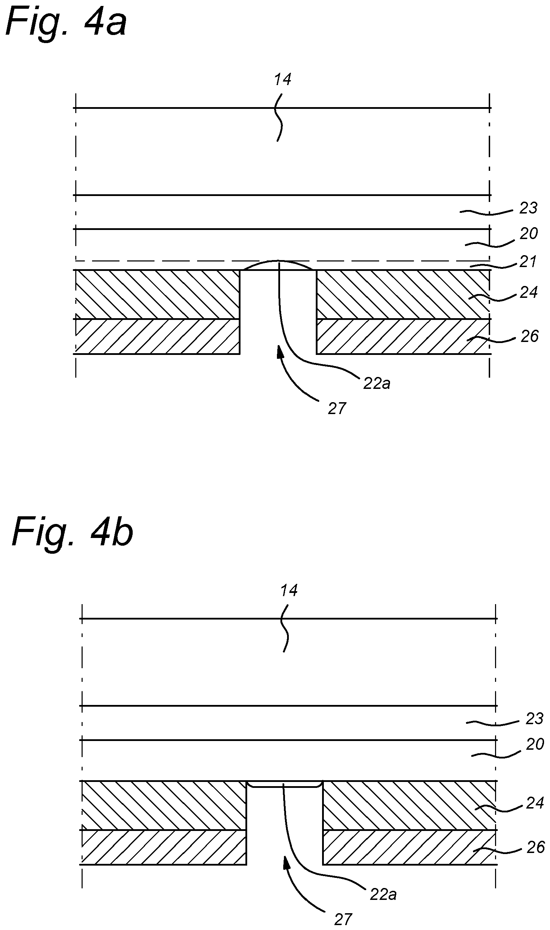

Each of these method steps can be applied to both patches for connecting to solar cell contacts or junction box conductor contacts, as will be described with reference to figures 3a - 3c and 4a - 4c.

According to an aspect of the invention there is provided a method as described above, wherein the application of the second conductive material comprises one selected from a group comprising ultrasonic bonding of the second conductive material on the first conductive material, chemical plating of the second conductive material on the first conductive material, and creating a coating of the second conductive material on the first conductive material by a pyrotechnic multilayered film.

In an exemplary case for a junction box conductor contact, a piece of copper (for example, a thin plate, or foil) can be ultrasonically bonded to the aluminum after the back-sheet has been opened on the rear side at the location of the contacts. The most probable process is to open the polymer layer before the module is built (i.e. before lamination) and bond the copper material to the back sheet using a large bond head to maximize the bond area. Bonding can be done from the copper or the aluminum side of the back-sheet. The module is then built and laminated after which the cables can be soldered to the copper. The thin plate or foil to be bonded may have a size corresponding to a size of the opening in the back sheet.

Chemical plating of a second conductive material could be achieved by limiting the presence of corrosive and reactive agents forming the patch of second conductive material, to the opening that defines the location of the patch to be created during the deposition process. For example, a masking technique could be applied.

The patch of second conductive material could alternatively be created by a pyrotechnic technique in which a multilayered foil is arranged in the opening in the polymer layer at the location of the patch to be created. The multilayered foil consists of thin layers of two (or more) different materials arranged in a stack. The stacked arrangement is typically metastable as the different materials would form a compound as a reaction product in an exothermic reaction. The exothermic reaction could be triggered by a heat pulse. The reaction heat from the exothermic reaction will produce a bonding of the compound as a patch of second conductive material on the first conductive material.

Figure 3A shows a cross-section of the patterned conductor circuit layer at a location of a contacting area with a rear contact of a solar cell. It has been found that during cold spraying the particles of the second conductive material powder penetrate a the native oxide layer 21 on the aluminum based material, form a local patch 22 of the second conductive material that directly contacts the aluminum based material.

As a result the contact between the solder body or conductive adhesive on the solar cell and the conductor circuit layer is improved: The local patch 22 has the properties of the second conductive material that allow a proper electrical contact and mechanical contact with the solder body or conductive adhesive 19. At the same time the local patch has a proper electrical contact and mechanical contact with the aluminum based material of the conductor circuit layer 20.

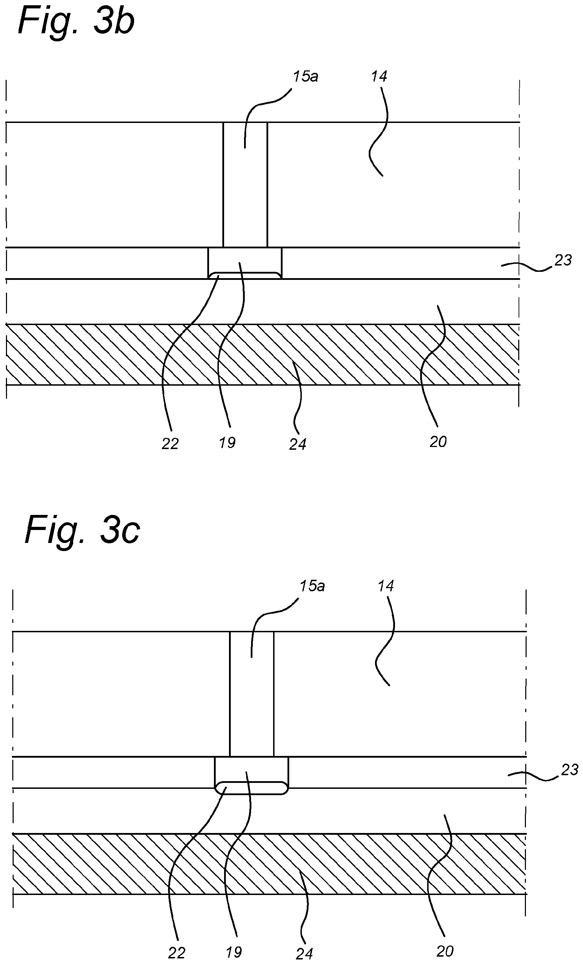

Figure 3B shows a cross-section of the patterned conductor circuit layer at a location of a contacting area with a rear contact of a solar cell. A local patch 22 of the second conductive material is created on the patterned conductor circuit layer by an ultrasonic bonding of a thin plate or foil of the second material on the first conductive material of the conductor circuit layer.

Alternatively, the local patch 22 can be created by a chemical or electrochemical plating process. The plating process involves a creation of the local patch of second conductive material from a plating fluid at the location on the patterned conductor circuit layer where the first conductive material is exposed to the plating fluid.

To avoid that plating takes place at undesired locations on the patterned conductor circuit layer and/or corrosion of the first conductive material takes place at undesired locations, the plating may be localized by a selective exposure of the first conductive material at locations where the local patches 22 are to be formed. Selective exposure can be achieved by a suitable masking layer technique as will be readily understood by the skilled in the art.

Figure 3C shows a cross-section of the patterned conductor circuit layer at a location of a contacting area with a rear contact of a solar cell. According to an embodiment, a local patch 22 of second conductive material on the first conductive material is created by a pyrotechnic process involving application of a multilayered foil at a location on the patterned circuit conductor layer of first conductive material where the local patch 22 is to be created. By exothermic reaction of the materials in the multilayered foil a bonding of the reaction product compound as a patch of second conductive material with the first conductive material takes place.

In a similar manner, junction box conductor contacts can be fabricated as will be explained below with reference to figures 4A - 4C.

Figure 4A shows a cross-section of the patterned conductor circuit layer at a location of a second contacting area of the circuit layer with a contact of a junction box created by the cold spraying method. From the rear side of the solar panel module, the support layer 26 and isolation carrier 24 are locally opened at a position 27 where a contact of a junction box will be located when the junction box is mounted at the rear side of the solar panel.

The created opening exposes the back surface of the patterned conductor circuit layer where the contact of the junction box is to be connected.

According to an embodiment of the invention in the second contacting area of the patterned conductor circuit layer a local patch 22a of the second conductive material is arranged. According to the invention, the local patch 22a is applied on the circuit layer by means of cold spraying in a similar manner as the local patch arranged in between the circuit layer and a rear contact of the solar cell.

Figure 4B shows a cross-section of the patterned conductor circuit layer at a location of a second contacting area of the circuit layer with a local patch 22a for contact with a junction box conductor created by either ultrasonic bonding or chemical/electrochemical plating.

In case of ultrasonic bonding to create the local patches, the local patches 22a may be created prior to the application of the support layer 26 and isolation carrier 24, at the locations 27 where a contact of a junction box will be located at the rear side of the solar panel. After application of the local patches 22a, the support layer 26 and the isolation carrier 24 are arranged on the rear side over the patterned conductor circuit layer. Subsequently, openings in the support layer 26 and the isolation carrier 24 are made to expose the local patches 22a. The junction box conductors are then bonded or soldered to the local patches 22a.

In case of a plating method to create the local patches 22a from the rear side of the solar panel module, the support layer 26 and isolation carrier 24 can be mounted optionally before the plating process. The support layer 26 and the isolation carrier 24 are locally opened at positions 27 where a contact of a junction box will be located at the rear side of the solar panel.

The created opening exposes the back surface of the patterned conductor circuit layer where the contact of the junction box is to be connected.

A local isolation or masking technique may be applied to prevent the plating fluid from spreading away from the created openings and/or contacting other areas of the solar panel module.

After forming the local patches 22a, the junction box conductors are then bonded or soldered to the local patches 22a.

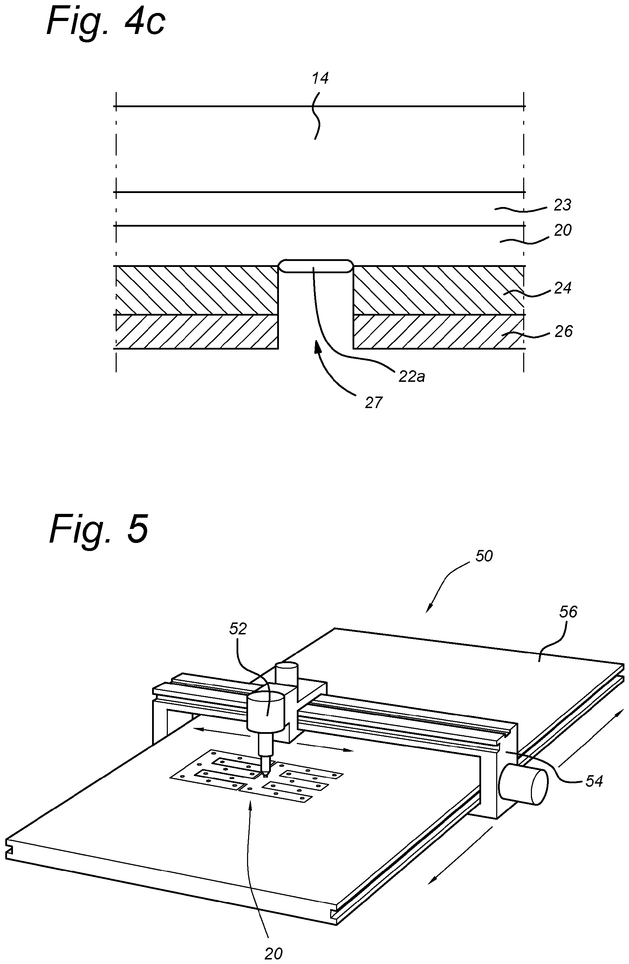

Figure 4C shows a cross-section of the patterned conductor circuit layer at a location of a second contacting area of the circuit layer with a contact of a junction box created by the pyrotechnic bonding method.

The local patches 22a are created at the locations 27 where a contact of a junction box will be located at the rear side of the solar panel.

A multilayered foil piece is arranged at the location on the patterned circuit conductor layer of first conductive material where the local patch 22a is to be created. By exothermic reaction of the materials in the multilayered foil a bonding of the reaction product compound as a patch of second conductive material with the first conductive material takes place.

This can be done either before or after the application of the support layer 26 and isolation carrier 24.

In case the local patches 22a are to be formed before the application of the support layer 26 and the isolation carrier 24, the support layer and isolation carrier are mounted over the patterned conductor circuit layer holding the local patches 22a. Subsequently, openings need to be created at the location(s) of the local patch(es) before the junction box conductors can be bonded/soldered to the local patches 22a.

In case the local patches 22a are to be formed after the application of the support layer 26 and the isolation carrier 24, the support layer and isolation carrier are arranged over the patterned conductor circuit layer in a preceding step. Next, from the rear side of the solar panel module, the support layer 26 and isolation carrier 24 are locally opened at a position 27 where a contact of a junction box will be located when the junction box is mounted at the rear side of the solar panel. Then, the local patches 22a are created in the local openings by the pyrotechnic method described above.

Subsequently, the local patches 22a are contacted to the junction box conductors by a bonding or soldering technique.

Figure 5 shows schematically a tool 50 according to an embodiment of the invention.

The tool 50 comprises a spraying device 52, a positioning robot 54 and a supporting table 56. The supporting table 56 is arranged for supporting a back sheet layer comprising the conductor circuit layer 20 and its insulating carrier layer 24. The spraying device 52 is arranged for cold spraying powder of the second conductive material through a nozzle at predetermined locations on the conductor circuit layer, the predetermined locations corresponding with the locations of the contacts on the solar cells to be placed on the conductor circuit layer.

The spraying device 52 is mounted on a movable part of the robot that can be positioned at substantially any position above the plane of the supporting table. Such a movable part could a X-Y movable arm.

In an embodiment, the tool 50 may be combined with a milling device (not shown) configured for milling the conductor circuit layer into a predetermined pattern as described above. The milling device can be mounted on the same movable part as the spraying device or on an additional movable part of the robot.

In an embodiment, the tool combined with the milling device is arranged to create openings in the rear surface of the support layer 26 and isolation carrier 24 up to the interface with the patterned conductor circuit layer 20 so as to expose the rear surface of the patterned conductor circuit layer 20. After milling to create an opening in the rear surface, the spraying device 52 can be positioned over the opening and apply the local patch 22a through the opening onto the exposed patterned conductor circuit layer 20.

It will be appreciated that the invention provides that on a first conductive material of a solar panel's patterned conductor circuit layer local patches of a second conductive material with relatively high quality and good bonding or soldering properties are applied on the patterned conductor circuit layer for only either solar cell contacts or junction box conductor contacts, or for any combination of solar cell contacts and junction box conductor contacts.

The methods according to the invention may be applied for only either solar cell contacts or junction box conductor contacts, or for combinations of solar cell contacts and junction box conductor contacts.

Accordingly, the present invention relates to a solar panel provided with a stack comprising at least one solar cell and a back-sheet layer; the at least one solar cell being arranged as a back contacted solar cell with a front surface for receiving radiation and a rear surface provided with electrical contacts; the solar panel further being arranged for electrically contacting to a junction box having one or more conductor contacts; the back-sheet layer having a surface provided with a patterned conductor circuit layer of a first conductive material, the conductor circuit layer being arranged with contacting areas each located at a location corresponding and aligned to a location of one of the electrical contacts on the at least one solar cell;
the at least one solar cell being arranged on top of the conductor circuit layer with the rear surface of the at least one solar cell facing the patterned conductor circuit surface; each electrical contact of the at least one solar cell being in conductive contact with a corresponding one of the contacting areas on the conductor circuit by a body of conductive connecting material; the conductor circuit layer comprising at the location of the contacting area a patch or islet of a second conductive material wherein each patch is arranged in between the body of conductive connecting material on either the one electrical contact of the solar cell and the layer of the first conductive material.

Likewise, the present invention relates to a solar panel provided with a stack comprising at least one solar cell and a back-sheet layer; the at least one solar cell being arranged as a back contacted solar cell with a front surface for receiving radiation and a rear surface provided with electrical contacts; the solar panel further being arranged for electrically contacting to a junction box having one or more conductor contacts; the back-sheet layer having a surface provided with a patterned conductor circuit layer of a first conductive material, the conductor circuit layer being arranged with contacting areas each located at a location corresponding and aligned to a location of one of junction box conductor contacts;
the at least one solar cell being arranged on top of the conductor circuit layer with the rear surface of the at least one solar cell facing the patterned conductor circuit surface; each junction box conductor contact being in conductive contact with a corresponding one of the contacting areas on the conductor circuit by a body of conductive connecting material; the conductor circuit layer comprising at the location of the contacting area a patch or islet of a second conductive material wherein each patch is arranged in between the body of conductive connecting material on the one junction box conductor contact and the layer of the first conductive material.

The present invention relates to a method for manufacturing a solar panel provided with a stack comprising at least one solar cell, a back-sheet layer and a junction box, comprising:
- providing the at least one solar cell being arranged as a back contacted solar cell with a front surface for receiving radiation and a rear surface provided with electrical contacts;
- providing a back-sheet layer having a conductive surface of a first conductive material;
- patterning the conductive surface with a conductor circuit layer being arranged with a layout of contacting areas each located at a location corresponding and aligned to a location of a corresponding one of the electrical contacts on the at least one solar cell;
- placing the at least one solar cell on top of the conductor circuit layer with the rear surface of the at least one solar cell facing the patterned conductor circuit surface;
- conductively contacting either each electrical contact of the at least one solar cell with a corresponding one of the contacting areas on the conductor circuit by a body of conductive connecting material;
- creating at the location of each contacting area a patch or islet of a second conductive material before said conductively contacting each electrical contact with the corresponding contacting area, with each patch being arranged in between the body of conductive connecting material on the respective one electrical contact of the solar cell and the layer of the first conductive material, wherein the creation of each patch comprises an application of a second conductive material.

The present invention relates to a method for manufacturing a solar panel provided with a stack comprising at least one solar cell, a back-sheet layer and a junction box, comprising:
- providing the at least one solar cell being arranged as a back contacted solar cell with a front surface for receiving radiation and a rear surface provided with electrical contacts;
- providing a back-sheet layer having a conductive surface of a first conductive material;
- patterning the conductive surface with a conductor circuit layer being arranged with a layout of contacting areas each located at a location corresponding and aligned to a location of corresponding one of junction box contacts;
- placing the at least one solar cell on top of the conductor circuit layer with the rear surface of the at least one solar cell facing the patterned conductor circuit surface;
- conductively contacting each junction box conductor contact with a corresponding one of the contacting areas on the conductor circuit by a body of conductive connecting material;
- creating at the location of each contacting area a patch or islet of a second conductive material before said conductively contacting each electrical contact with the corresponding contacting area, with each patch being arranged in between the body of conductive connecting material on the one junction box conductor contact and the layer of the first conductive material, wherein the creation of each patch comprises an application of a second conductive material.

The invention has been described with reference to the preferred embodiment. Obvious modifications and alterations will occur to others upon reading and understanding the preceding detailed description. It is intended that the invention be construed as including all such modifications and alterations the scope of the invention being limited only by the appended claims.

## Claims

1. A solar panel (1) provided with a stack comprising at least one solar cell (14) and a back-sheet layer (24); the at least one solar cell (1) being arranged as a back contacted solar cell with a front surface (10) for receiving radiation and a rear surface (11) provided with electrical contacts (15, 17); the solar panel further being arranged for electrically contacting to a junction box having one or more conductor contacts; the back-sheet layer having a surface provided with a patterned conductor circuit layer (20; 32, 33, 34) of a first conductive material, the conductor circuit layer (20; 32, 33, 34) being arranged with contacting areas each located at a location corresponding and aligned to a location of either one of the electrical contacts (15, 17) on the at least one solar cell (14) or one of junction box conductor contacts (27);
the at least one solar cell (14) being arranged on top of the conductor circuit layer (20) with the rear surface (11) of the at least one solar cell (14) facing the patterned conductor circuit surface (32, 33, 34);
each electrical contact of the at least one solar cell (14) or junction box conductor contact being in conductive contact with a corresponding one of the contacting areas on the conductor circuit by a body of conductive connecting material (19);
**characterized in that** the first conductive material is an aluminum based metal, the conductor circuit layer (20) comprises at the location of the contacting area a local patch (22; 22a) or islet of a second conductive material wherein each local patch is arranged in between the body of conductive connecting material (23) on either the one electrical contact (15, 17) or the one junction box conductor contact (27) and the layer of the first conductive material (20; 32, 33, 34), and the local patch (22; 22a) has penetrated a native oxide layer on the aluminum based metal and directly contacts the aluminum based metal.

2. A solar panel (1) according to claim 1, wherein the second conductive material is selected from a group comprising a copper based material, a tin based material and a nickel based material.

3. A solar panel according to any one of the preceding claims, wherein each patch (22;22a) has an areal size that substantially matches the area of an electric contact on the solar cell (14).

4. A solar panel (1) according to claim 3, wherein the patch (22;22a) areal size has a diameter of about 2 mm.

5. A solar panel (1) according to any one of the preceding claims, wherein a thickness of the islets of second conductive material (22; 22a) does not exceed 50 micron.

6. A solar panel (1) according to any one of the preceding claims, wherein the solar panel comprises a back panel (26) that covers a rear surface of the solar panel, the back panel (26) being provided with openings that correspond with and are aligned to a respective location of each of the junction box conductor contacts (27).

7. A method for manufacturing a solar panel (1) provided with a stack comprising at least one solar cell (14), a back-sheet layer (24) and a junction box, comprising:
- providing the at least one solar cell (14) being arranged as a back contacted solar cell with a front surface (10) for receiving radiation and a rear surface (11) provided with electrical contacts (15, 17);
- providing a back-sheet layer (24) having a conductive surface of a first conductive material being an aluminum based metal;
- patterning the conductive surface with a conductor circuit layer (20; 32, 33, 34) being arranged with a layout of contacting areas, each contacting area located at a location corresponding and aligned to a location of either a corresponding electrical contact (15, 17) on the at least one solar cell or a corresponding junction box contact (27);
- placing the at least one solar cell (14) on top of the conductor circuit layer (20; 32, 33, 34) with the rear surface (11) of the at least one solar cell (14) facing the patterned conductor circuit surface;
- conductively contacting either each electrical contact (15,17) of the at least one solar cell (14) or each junction box conductor contact (27) with the corresponding contacting area on the conductor circuit (20; 32, 33, 34) by a body of conductive connecting material (19);
- creating at the location of each contacting area a local patch (22; 22a) or islet of a second conductive material before said conductively contacting each electrical contact (15, 17) with the corresponding contacting area (19), with each local patch (22; 22a) being arranged in between the body of conductive connecting material (19) on either one electrical contact (15, 17) or one junction box conductor contact (27) and the layer of the first conductive material (20), wherein the creation of each local patch (22; 22a) comprises application of a second conductive material, with the local patch (22; 22a) having penetrated a native oxide layer on the aluminum based metal and directly contacting the aluminum based metal.

8. A method according to claim 7, wherein the application of the second conductive material comprises a cold spraying by a spraying device (52).

9. A method according to claim 8, wherein the second conductive material is applied on the first conductive material by cold spraying, which includes mixing a powder of the second conductive material with a gas flow, spraying the mixed powder at high flow rate and at relatively low temperature on the surface of the first conductive based material.

10. A method according to claim 7, wherein the application of the second conductive material comprises one selected from a group comprising ultrasonic bonding of the second conductive material on the first conductive material, chemical or electrochemical plating of the second conductive material on the first conductive material.

11. A method according to claim 7, wherein the application of the second conductive material comprises creating a coating of the second conductive material on the first conductive material by a pyrotechnic multilayered film or foil.

12. A method according to any one of the preceding claims 7 - 11, comprising:
- selecting the second conductive material from a group comprising a copper based material, a tin based material and a nickel based material.

13. A method according to any one of the preceding claims 7 - 12, further comprising:
- providing a back panel (26) that covers a rear surface of the solar panel (1);
- creating openings in the back panel (26) that correspond and are aligned to a respective location of each of the junction box conductor contacts (27).

14. A method according to any one of the preceding claims 7 - 13, wherein preceding the application of the second conductive material, a masking layer is positioned on the conductor circuit layer (20; 32, 33, 34); openings in the masking layer being defined for exposing the location of each patch (22; 22a) on the conductor circuit layer (20; 32, 33, 34) during the application of the second conductive material.

15. A method according to any one of the preceding claims 7 - 14, wherein the back-sheet layer comprises an insulating carrier layer (24) and a conductive layer of the first conductive material and
said patterning the conductive surface of the back sheet comprises milling the back sheet to create the conductor circuit layer (20; 32, 33, 34).

16. A method according to claim 15, wherein the insulating carrier layer (24) comprises either a base polymer layer or a base glass layer or in general a base insulating material layer.

17. A method according to any one of the preceding claims 7 - 16 as far as dependent on claim 8, wherein the cold spraying comprises positioning an outlet of the spraying device (52) at the location of each contacting area on the conductor circuit layer (20; 32, 33, 34) that corresponds to the location of the corresponding electrical contact (15, 17) on the at least one solar cell (14) or to the location of the corresponding junction box contact (27).

18. A method according to claim 17, wherein the positioning of the outlet of the spraying device (52) is done by a positioning robot (54).

19. A method according to any one of the preceding claims 7, 8, 11 - 18, wherein preceding the application of the second conductive material, a masking layer is positioned on the conductor circuit layer; openings in the masking layer being defined for exposing the location of each patch (22; 22a) on the conductor circuit layer (20; 32, 33, 34) during the application of the second conductive material.

20. A method according to claim 19, further comprising: removal of the masking layer after said application.

21. A method according to any one of the preceding claims 10 - 20, as far as dependent on claim 10, further comprising:
- from a rear side of the solar panel (1) creating an opening in at least the insulating carrier layer (24) upto an interface between the insulating carrier layer (24) and the first conductive material layer (20);
- creating at the location of the opening in at least the insulating carrier layer (24) a rear surface local patch (22;22a) or islet of the second conductive material in the first conductive material layer (20; 32, 33, 34);
- conductively contacting a contact of a junction box device (27) with the rear surface local patch (22; 22a) of second conductive material through the opening in at least the insulating carrier layer (24), wherein the creation of each rear surface local patch (22; 22a) comprises the application of the second conductive material by a spraying device (52), with the rear surface local patch having penetrated a native oxide layer on the aluminum based metal and directly contacting the aluminum based metal.

22. A method according to claim 21, comprising:
providing at the rear side of the solar panel (1) a support layer or back-panel (26) on the insulating carrier layer (24), and before the creation of the opening in the insulating carrier layer (24), creating an opening in the support layer (26) to the insulating carrier layer.

## Patentansprüche

1. Solarpaneel (1), das mit einem Stapel versehen ist, der wenigstens eine Solarzelle (14) und eine Rückschicht (24) umfasst, wobei die wenigstens eine Solarzelle (14) als eine rückkontaktierte Solarzelle mit einer Vorderfläche (10) für das Empfangen einer Strahlung und einer Rückfläche (11), die mit elektrischen Kontakten (15, 17) versehen ist, angeordnet ist, wobei das Solarpaneel weiterhin angeordnet ist für ein elektrisches Kontaktieren einer Anschlussdose, die einen oder mehrere Leiterkontakte aufweist, wobei die Rückschicht eine Fläche aufweist, die mit einer gemusterten Leiterschaltungsschicht (20; 32, 33, 34) aus einem ersten leitenden Material versehen ist, wobei die Leiterschaltungsschicht (20; 32, 33, 34) mit Kontaktbereichen angeordnet ist, die jeweils an einer Position positioniert sind, die einer Position eines der elektrischen Kontakte (15, 17) an der wenigstens einen Solarzelle (14) oder eines der Anschlussdosen-Leiterkontakte (27) entspricht und mit dieser ausgerichtet ist,
wobei die wenigstens eine Solarzelle (14) über der Leiterschaltungsschicht (20) angeordnet ist, wobei die Rückfläche (11) der wenigstens einen Solarzelle (14) der gemusterten Leiterschaltungsfläche (32, 33, 34) zugewandt ist,
wobei jeder elektrische Kontakt der wenigstens einen Solarzelle (14) oder des Anschlussdosen-Leiterkontakts in einem leitenden Kontakt mit einem entsprechenden der Kontaktbereiche an der Leiterschaltung über einen Körper aus einem leitenden Verbindungsmaterial (19) ist,
**dadurch gekennzeichnet, dass**
das erste leitende Material ein Aluminium-basiertes Metall ist, wobei die Leiterschaltungsschicht (20) an der Position des Kontaktbereichs eine lokale Insel (22; 22a) aus einem zweiten leitenden Material aufweist, wobei jede lokale Insel zwischen dem Körper des leitenden Verbindungsmaterials (23) an entweder dem einen elektrischen Kontakt (15, 17) oder dem einen Anschlussdosen-Leiterkontakt (27) und der Schicht aus dem ersten leitenden Material (20; 32, 33, 34) angeordnet ist, wobei sich die lokale Insel (22; 22a) in eine native Oxidschicht an dem Aluminium-basierten Metall erstreckt und das Aluminium-basierte Metall direkt kontaktiert.

2. Solarpaneel (1) nach Anspruch 1, wobei das zweite leitende Material aus einer Gruppe ausgewählt ist, die ein Kupfer-basiertes Material, ein Zinn-basiertes Material und ein Nickel-basiertes Material umfasst.

3. Solarpaneel nach einem der vorstehenden Ansprüche, wobei jede Insel (22; 22a) eine Flächengröße aufweist, die im Wesentlichen der Fläche eines elektrischen Kontakts an der Solarzelle (14) entspricht.

4. Solarpaneel (1) nach Anspruch 3, wobei die Flächengröße der Insel (22; 22a) einen Durchmesser von ungefähr 2 mm aufweist.

5. Solarpaneel (1) nach einem der vorstehenden Ansprüche, wobei die Dicke der Inseln des zweiten leitenden Materials (22; 22a) nicht größer als 50 Mikrometer ist.

6. Solarpaneel (1) nach einem der vorstehenden Ansprüche, wobei das Solarpaneel ein Rückpaneel (26) umfasst, das eine Rückfläche des Solarpaneels bedeckt, wobei das Rückpaneel (26) mit Öffnungen versehen ist, die einer entsprechenden Position jedes der Anschlussdosen-Leiterkontakte (27) entsprechen und mit dieser ausgerichtet sind.

7. Verfahren zum Herstellen eines Solarpaneels (1), das mit einem Stapel versehen ist, der wenigstens eine Solarzelle (14), eine Rückschicht (24) und eine Anschlussdose umfasst, umfassend:
- Vorsehen der wenigstens einen Solarzelle (14), die als eine rückkontaktierte Solarzelle mit einer Vorderfläche (10) für das Empfangen einer Strahlung und einer Rückfläche (11), die mit elektrischen Kontakten (15, 17) versehen ist, angeordnet ist,
- Vorsehen der Rückschicht (24), die eine leitende Fläche aus einem ersten leitenden Material, das ein Aluminium-basiertes Metall ist, aufweist,
- Mustern der leitenden Fläche mit einer Leiterschaltungsschicht (20; 32, 33, 34), die mit einem Layout aus Kontaktbereichen angeordnet ist, wobei jeder Kontaktbereich an einer Position positioniert ist, die einer Position eines entsprechenden elektrischen Kontakts (15, 17) an der wenigstens einen Solarzelle (14) oder eines entsprechenden Anschlussdosen-Leiterkontakts (27) entspricht und mit dieser ausgerichtet ist,
- Platzieren der wenigstens einen Solarzelle (14) über der Leiterschaltungsschicht (20; 32, 33, 34), wobei die Rückfläche (11) der wenigstens einen Solarzelle (14) der gemusterten Leiterschaltungsfläche zugewandt ist,
- leitendes Kontaktieren jedes elektrischen Kontakts (15, 17) der wenigstens einen Solarzelle (14) oder jedes Anschlussdosen-Leiterkontakts (27) mit dem entsprechenden Kontaktbereich an der Leiterschaltung (20; 32, 33, 34) durch einen Körper aus einem leitenden Verbindungsmaterial (19),
- Erzeugen, an der Position jedes Kontaktbereichs, einer lokalen Insel (22; 22a) aus einem zweiten leitenden Material vor dem leitenden Kontaktieren jedes elektrischen Kontakts (15, 17) mit dem entsprechenden Kontaktbereich (19), wobei jede lokale Insel (22; 22a) zwischen dem Körper des leitenden Verbindungsmaterials (19) an einem elektrischen Kontakt (15, 17) oder einem Anschlussdosen-Leiterkontakt (27) und der Schicht des ersten leitenden Materials (20) angeordnet ist, wobei das Erzeugen jeder lokalen Insel (22; 22a) das Auftragen eines zweiten leitenden Materials umfasst, wobei sich die lokale Insel (22; 22a) in eine native Oxidschicht an dem Aluminium-basierten Metall erstreckt und das Aluminium-basierte Metall direkt kontaktiert.

8. Verfahren nach Anspruch 7, wobei das Auftragen des zweiten leitenden Materials ein Kaltsprühen durch eine Sprüheinrichtung (52) umfasst.

9. Verfahren nach Anspruch 8, wobei das zweite leitende Material auf dem ersten leitenden Material durch ein Kaltsprühen aufgetragen wird, das das Mischen eines Pulvers des zweiten leitenden Materials mit einem Gasfluss und das Sprühen des gemischten Pulvers mit einer hohen Flussrate und mit einer relativ niedrigen Temperatur auf die Fläche des ersten leitenden Materials umfasst.

10. Verfahren nach Anspruch 7, wobei das Auftragen des zweiten leitenden Materials eine ausgewählte Methode aus der Gruppe umfasst, die das Ultraschallbonden des zweiten leitenden Materials auf dem ersten leitenden Material und das chemische oder elektrochemische Plattieren des zweiten leitenden Materials auf dem ersten leitenden Material umfasst.

11. Verfahren nach Anspruch 7, wobei das Auftragen des zweiten leitenden Materials das Erzeugen einer Beschichtung aus dem zweiten leitenden Material auf dem ersten leitenden Material durch einen pyrotechnischen, mehrschichtigen Film oder eine pyrotechnische, mehrschichtige Folie umfasst.

12. Verfahren nach einem der vorstehenden Ansprüche 7-11, das umfasst:
- Auswählen des zweiten leitenden Materials aus einer Gruppe, die ein Kupfer-basiertes Material, ein Zinn-basiertes Material und ein Nickel-basiertes Material umfasst.

13. Verfahren nach einem der vorstehenden Ansprüche 7-12, das weiterhin umfasst:
- Vorsehen eines Rückpaneels (26), das eine Rückfläche des Solarpaneels (1) bedeckt,
- Erzeugen von Öffnungen in dem Rückpaneel (26), die einer entsprechenden Position jedes der Anschlussdosen-Leiterkontakte (27) entsprechen und mit dieser ausgerichtet sind.

14. Verfahren nach einem der vorstehenden Ansprüche 7-13, wobei vor dem Auftragen des zweiten leitenden Materials eine Maskierungsschicht auf der Leiterschaltungsschicht (20; 32, 33, 34) positioniert wird, wobei Öffnungen in der Maskierungsschicht für das Freilegen der Position jeder Insel (22; 22a) an der Leiterschaltungsschicht (20; 32, 33, 34) während des Auftragens des zweiten leitenden Materials definiert sind.

15. Verfahren nach einem der vorstehenden Ansprüche 7-14, wobei die Rückschicht eine isolierende Trägerschicht (24) und eine leitende Schicht aus dem ersten leitenden Material umfasst und wobei das Mustern der leitenden Fläche der Rückschicht das Fräsen der Rückschicht für das Erzeugen der Leiterschaltungsschicht (20; 32, 33, 34) umfasst.

16. Verfahren nach Anspruch 15, wobei die isolierende Trägerschicht (24) eine Basispolymerschicht oder eine Basisglasschicht oder allgemein eine isolierende Basismaterialschicht umfasst.

17. Verfahren nach einem der vorstehenden Ansprüche 7-16, sofern diese von Anspruch 8 abhängig sind, wobei das Kaltsprühen das Positionieren eines Auslasses der Sprüheinrichtung (52) an einer Position jedes Kontaktbereichs an der Leiterschaltungsschicht (20; 32, 33, 34), die der Position des entsprechenden elektrischen Kontakts (15, 17) an der wenigstens einen Solarzelle (14) oder der Position des entsprechenden Anschlussdosenkontakts (27) entspricht, umfasst.

18. Verfahren nach Anspruch 17, wobei das Positionieren des Auslasses der Sprühvorrichtung (52) durch einen Positionierungsroboter (54) bewerkstelligt wird.

19. Verfahren nach einem der vorstehenden Ansprüche 7, 8, 11-18, wobei vor dem Auftragen des zweiten leitenden Materials eine Maskierungsschicht auf der Leiterschaltungsschicht positioniert wird, wobei Öffnungen in der Maskierungsschicht für das Freilegen der Position jeder Insel (22; 22a) an der Leiterschaltungsschicht (20; 32, 33, 34) während des Auftragens des zweiten leitenden Materials definiert sind.

20. Verfahren nach Anspruch 19, das weiterhin umfasst:
Entfernen der Maskierungsschicht nach dem Auftragen.

21. Verfahren nach einem der vorstehenden Ansprüche 10-20, sofern diese von dem Anspruch 10 abhängig sind, das weiterhin umfasst:
- von einer Rückseite des Solarpaneels (1), Erzeugen einer Öffnung in wenigstens der isolierenden Trägerschicht (24) bis zu einer Schnittfläche zwischen der isolierenden Trägerschicht (24) und der ersten leitenden Materialschicht (20),
- Erzeugen, an der Position der Öffnung in wenigstens der isolierenden Trägerschicht (24), einer lokalen Rückflächeninsel (22; 22a) aus dem zweiten leitenden Material in der ersten leitenden Materialschicht (20; 32, 33, 34),
- leitendes Kontaktieren eines Kontakts einer Anschlussdoseneinrichtung (27) mit der lokalen Rückflächeninsel (22; 22a) aus dem zweiten leitenden Material durch die Öffnung in wenigstens der isolierenden Trägerschicht (24), wobei das Erzeugen jeder lokalen Rückflächeninsel (22; 22a) das Auftragen des zweiten leitenden Materials durch eine Sprüheinrichtung (52) umfasst, wobei sich die lokale Rückflächeninsel zu einer nativen Oxidschicht an dem Aluminium-basierten Metall erstreckt und das Aluminium-basierte Metall direkt kontaktiert.

22. Verfahren nach Anspruch 21, umfassend:
Vorsehen, an der Rückseite des Solarpaneels (1), einer Halteschicht oder eines Rückpaneels (26) an der isolierenden Trägerschicht (24), und, vor dem Erzeugen der Öffnung in der isolierenden Trägerschicht (24), Erzeugen einer Öffnung in der Halteschicht (26) zu der isolierenden Trägerschicht.

## Revendications

1. Panneau solaire (1) pourvu d'un empilement comprenant au moins une cellule solaire (14) et une couche formant feuillet arrière (24) ; ladite au moins une cellule solaire (1) étant disposée comme une cellule solaire à contact arrière pourvue d'une surface avant (10) destinée à recevoir du rayonnement et d'une surface arrière (11) munie de contacts électriques (15, 17) ; le panneau solaire étant en outre disposé de manière à être en contact électrique avec une boîte de jonction ayant un ou plusieurs contacts de conducteur ; la couche formant feuillet arrière ayant une surface pourvue d'une couche de circuit de conducteur à motifs (20 ; 32, 33, 34) d'un premier matériau conducteur, la couche de circuit de conducteur (20 ; 32, 33, 34) étant disposée avec des zones de contact situées chacune à un emplacement correspondant et alignées à un emplacement de l'un des contacts électriques (15, 17) sur ladite au moins une cellule solaire (14) ou de l'un des contacts de conducteur (27) de la boîte de jonction ;
ladite au moins une cellule solaire (14) étant disposée au-dessus de la couche de circuit de conducteur (20) avec la surface arrière (11) de ladite au moins une cellule solaire (14) orientée vers la surface de circuit de conducteur à motifs (32, 33, 34) ;
chaque contact électrique de ladite au moins une cellule solaire (14) ou chaque contact de conducteur de la boîte de jonction étant en contact conducteur avec l'une des zones de contact correspondante du circuit de conducteur par le biais d'un corps de matériau de connexion conducteur (19) ;
**caractérisé en ce que** le premier matériau conducteur est un métal à base d'aluminium, la couche de circuit de conducteur (20) comprend à l'emplacement de la zone de contact une pastille locale (22 ; 22a) ou un îlot d'un deuxième matériau conducteur dans lequel chaque pastille locale est disposée entre le corps de matériau de connexion conducteur (23) sur l'un des contacts électriques (15, 17) ou l'un des contacts de conducteur (27) de la boîte de jonction et la couche du premier matériau conducteur (20 ; 32, 33, 34), et la pastille locale (22 ; 22a) a pénétré une couche d'oxyde natif sur le métal à base d'aluminium et vient directement en contact avec le métal à base d'aluminium.

2. Panneau solaire (1) selon la revendication 1, dans lequel le deuxième matériau conducteur est choisi dans un groupe comprenant un matériau à base de cuivre, un matériau à base d'étain et un matériau à base de nickel.

3. Panneau solaire selon l'une quelconque des revendications précédentes, dans lequel chaque pastille (22 ; 22a) a une taille d'aire qui correspond sensiblement à l'aire d'un contact électrique sur la cellule solaire (14).

4. Panneau solaire (1) selon la revendication 3, dans lequel la taille de l'aire de la pastille (22 ; 22a) a un diamètre d'environ 2 mm.

5. Panneau solaire (1) selon l'une quelconque des revendications précédentes, dans lequel l'épaisseur des îlots du deuxième matériau conducteur (22 ; 22a) ne dépasse pas 50 microns.

6. Panneau solaire (1) selon l'une quelconque des revendications précédentes, dans lequel le panneau solaire comprend un panneau arrière (26) qui couvre une surface arrière du panneau solaire, le panneau arrière (26) étant pourvu d'ouvertures qui correspondent avec et sont alignées à un emplacement respectif de chacun des contacts de conducteur (27) de la boîte de jonction.

7. Procédé de fabrication d'un panneau solaire (1) pourvu d'un empilement comprenant au moins une cellule solaire (14), une couche formant feuillet arrière (24) et une boîte de jonction, comprenant les étapes suivantes :
- fournir ladite au moins une cellule solaire (14) étant disposée comme une cellule solaire à contact arrière pourvue d'une surface avant (10) destinée à recevoir du rayonnement et d'une surface arrière (11) munie de contacts électriques (15, 17) ;
- fournir une couche formant feuillet arrière (24) ayant une surface conductrice d'un premier matériau conducteur qui est un métal à base d'aluminium ;
- créer des motifs sur la surface conductrice avec une couche de circuit de conducteur (20 ; 32, 33, 34) étant disposée avec un agencement de zones de contact, chaque zone de contact étant située à un emplacement correspondant et alignée à un emplacement d'un contact électrique correspondant (15, 17) sur ladite au moins une cellule solaire ou d'un contact correspondant (27) de la boîte de jonction ;
- placer ladite au moins une cellule solaire (14) au-dessus de la couche de circuit de conducteur (20 ; 32, 33, 34) avec la surface arrière (11) de ladite au moins une cellule solaire (14) orientée vers la surface du circuit de conducteur à motifs;
- mettre en contact conducteur chaque contact électrique (15, 17) de ladite au moins une cellule solaire (14) ou chaque contact de conducteur (27) de la boîte de jonction avec la zone de contact correspondante sur le circuit de conducteur (20 ; 32, 33, 34) par le biais d'un corps de matériau de connexion conducteur (19) ;
- créer à l'emplacement de chaque zone de contact une pastille locale (22 ; 22a) ou un îlot d'un deuxième matériau conducteur avant ladite mise en contact conducteur de chaque contact électrique (15, 17) avec la zone de contact correspondante (19), avec chaque pastille locale (22 ; 22a) étant disposée entre le corps de matériau de connexion conducteur (19) sur un contact électrique (15, 17) ou un contact conducteur (27) de la boîte de jonction et la couche du premier matériau conducteur (20), dans lequel la création de chaque pastille locale (22 ; 22a) comprend l'application d'un deuxième matériau conducteur, avec la pastille locale (22 ; 22a) ayant pénétrée une couche d'oxyde natif sur le métal à base d'aluminium et venant directement en contact avec le métal à base d'aluminium.

8. Procédé selon la revendication 7, dans lequel l'application du deuxième matériau conducteur comprend une pulvérisation à froid par un dispositif de pulvérisation (52) .

9. Procédé selon la revendication 8, dans lequel le deuxième matériau conducteur est appliqué sur le premier matériau conducteur par pulvérisation à froid, qui comprend le mélange d'une poudre du deuxième matériau conducteur avec un écoulement de gaz, la pulvérisation du mélange de poudre à un débit élevé et à une température relativement basse sur la surface du premier matériau conducteur de base.

10. Procédé selon la revendication 7, dans lequel l'application du deuxième matériau conducteur comprend une sélection parmi un groupe comprenant le collage par ultrasons du deuxième matériau conducteur sur le premier matériau conducteur, le placage chimique ou électrochimique du deuxième matériau conducteur sur le premier matériau conducteur.

11. Procédé selon la revendication 7, dans lequel l'application du deuxième matériau conducteur comprend la création d'un revêtement du deuxième matériau conducteur sur le premier matériau conducteur par le biais d'un film ou d'une feuille multicouche pyrotechnique.

12. Procédé selon l'une quelconque des revendications précédentes 7 à 11, comprenant l'étape suivante :
- sélectionner le deuxième matériau conducteur dans le groupe comprenant un matériau à base de cuivre, un matériau à base d'étain et un matériau à base de nickel.

13. Procédé selon l'une quelconque des revendications précédentes 7 à 12, comprenant en outre les étapes suivantes :
- fournir un panneau arrière (26) qui couvre une surface arrière du panneau solaire (1) ;
- créer des ouvertures dans le panneau arrière (26) qui correspondent et sont alignées à un emplacement respectif de chacun des contacts de conducteur (27) de la boîte de jonction.

14. Procédé selon l'une quelconque des revendications précédentes 7 à 13, dans lequel, avant l'application du deuxième matériau conducteur, une couche de masquage est positionnée sur la couche de circuit de conducteur (20 ; 32, 33, 34) ; des ouvertures étant définies dans la couche de masquage pour exposer l'emplacement de chaque pastille (22 ; 22a) sur la couche de circuit de conducteur (20 ; 32, 33, 34) pendant l'application du deuxième matériau conducteur.

15. Procédé selon l'une quelconque des revendications précédentes 7 à 14, dans lequel la couche formant feuillet arrière comprend une couche de support isolante (24) et une couche conductrice du premier matériau conducteur et ladite création de motifs sur la surface conductrice du feuillet arrière comprend le fraisage du feuillet arrière pour créer la couche de circuit de conducteur (20 ; 32, 33, 34).

16. Procédé selon la revendication 15, dans lequel la couche de support isolante (24) comprend une couche de polymère de base ou une couche de verre de base ou, en général, une couche de matériau isolant de base.

17. Procédé selon l'une quelconque des revendications précédentes 7 à 16, dans la mesure où elles dépendent de la revendication 8, dans lequel la pulvérisation à froid comprend le positionnement d'une sortie du dispositif de pulvérisation (52) à l'emplacement de chaque zone de contact sur la couche de circuit de conducteur (20 ; 32, 33, 34) qui correspond à l'emplacement du contact électrique correspondant (15, 17) sur ladite au moins une cellule solaire (14) ou à l'emplacement du contact correspondant (27) de la boîte de jonction.

18. Procédé selon la revendication 17, dans lequel le positionnement de la sortie du dispositif de pulvérisation (52) est effectué par un robot de positionnement (54).

19. Procédé selon l'une quelconque des revendications précédentes 7, 8, 11 à 18, dans lequel, avant l'application du deuxième matériau conducteur, une couche de masquage est positionnée sur la couche de circuit de conducteur ; des ouvertures étant définies dans la couche de masquage pour exposer l'emplacement de chaque pastille (22 ; 22a) sur la couche de circuit de conducteur (20 ; 32, 33, 34) pendant l'application du deuxième matériau conducteur.

20. Procédé selon la revendication 19, comprenant en outre : l'enlèvement de la couche de masquage après ladite application.

21. Procédé selon l'une quelconque des revendications précédentes 10 à 20, dans la mesure où elles dépendent de la revendication 10, comprenant en outre les étapes suivantes :
- créer, depuis un côté arrière du panneau solaire (1), une ouverture dans au moins la couche de support isolante (24) jusqu'à une interface entre la couche de support isolante (24) et la couche du premier matériau conducteur (20) ;
- créer à l'emplacement de l'ouverture dans au moins la couche de support isolante (24) un pastille locale de surface arrière (22 ; 22a) ou un îlot du deuxième matériau conducteur dans la couche du premier matériau conducteur (20 ; 32, 33, 34) ;
- mettre en contact conducteur un contact d'un dispositif de boîte de jonction (27) avec la pastille locale de surface arrière (22 ; 22a) d'un deuxième matériau conducteur à travers l'ouverture dans au moins la couche de support isolante (24), dans lequel la création de chaque pastille locale de surface arrière (22 ; 22a) comprend l'application du deuxième matériau conducteur par un dispositif de pulvérisation (52), avec la pastille locale de surface arrière ayant pénétré une couche d'oxyde natif sur le métal à base d'aluminium et venant directement en contact avec le métal à base d'aluminium.

22. Procédé selon la revendication 21, comprenant l'étape suivante :
fournir sur le côté arrière du panneau solaire (1) une couche de support ou un panneau arrière (26) sur la couche de support isolante (24) et, avant de créer l'ouverture dans la couche de support isolante (24), créer une ouverture dans la couche de support (26) vers la couche de support isolante.
